# EUROPEAN PATENT APPLICATION

(11) **EP 1 936 806 A1**
(43) Date of publication of application: **25.06.2008**
(21) Application number: 06126857.9
(22) Date of filing: 21.12.2006
(51) Int. Cl.: H03K 17/96, A61N 1/372

(54) **Switch device for generating an electrical switch signal for a hearing aid circuitry**

(71) Applicant: Oticon A/S, 2765 Smørum (DK)
(72) Inventor: Nielsen, Christian, 2765 Smørum (DK)

(57) **Abstract**

A switching device for generating an electrical switching signal for a hearing aid circuitry is provided having improved actuating comfort for users of hearing aids and is adequate for a high degree of miniaturization. This switching device comprises a first piezoelectric element (7) excited by an electrical oscillator and generating mechanical oscillations transmitted via mechanical oscillation transmission means (10) to a second piezoelectric element (8) which, in turn, generates electrical oscillations from which the electrical switching signal is derived by processing means, preferably, after comparison with a threshold value. The mechanical oscillation transmission characteristic of the mechanical oscillation transmission means are modulated by modulating means (14) dependent from a mechanical input from the respective user of the hearing aid.

## Description

### BACKGROUND OF THE INVENTION

Switch devices for hearing aid circuitries encounter the problem of an extreme miniaturization of modern hearing aids if such switch devices are to be operated by the user of the respective hearing aid. It is an every day experience for hearing aid persons that they have trouble in operating tiny mechanical switches, particularly in situations, where the hearing impaired person may be nervous or confused by the environment so that a precise operation may cause considerable difficulties. Apart therefrom, extremely miniaturized operation elements for such switches on extremely miniaturized hearing aids may make it problematic for the user to generate precise operation movements e.g., with a finger tip which may have dimensions of another order of magnitude of the actuation element of the respective switch device. This results in generating of an electrical switch signal for a hearing aid circuitry either not at the correct or intended time or some cases with incorrect magnitude.

It is known from US 2002/0019669 A1 to provide a piezoelectric element to which a mechanic pressure signal is input as a control signal from a user in a totally implantable cochlear prothesis.

Implantable pressure sensitive switches to be operated by a mechanical signal from the user, e.g. for a defibrillator, is known from US 2005/0049647 A1.

### SUMMARY OF THE INVENTION

Having in mind the special problems with controlling IC devices in hearing aid circuitries by a mechanical input or a mechanical signal from a user of the hearing aid, it is the object of the present invention to provide a switch device for generating an electrical switch signal for a hearing aid circuitry which reliably generates an electrical switch signal comparatively precisely in time and amplitude respects even with a rather coarse mechanical input from a user of the hearing aid. Corrosion problems in a comparatively aggressive environment of a hearing aid are to be avoided with the switch device in accordance with the presently suggested design.

This object, in accordance with the present invention is achieved by a switch device having the features of enclosed claim 1.

Advantageous embodiments of such a switching device are subject-matter of the claims dependent from claim 1. The contents of these dependent claims are to be considered also as part of the present specification without repeating here the wording of such claims.

It is the basic idea of the present invention to implement the switch device used to set an IC in a hearing aid comprising two piezoelectric elements having a modulateable mechanical oscillation transmission means there-between. While the first piezoelectric crystal element is a transmitter of mechanical oscillations when excited by electrical oscillations, the second piezoelectric element is a receiver which, when being excited by the mechanical oscillations, has again electrical oscillations output for being used as electrical switch signal or being used for deriving an electrical switch signal for an IC device of the hearing aid.

Unpreciseness of the mechanical input from the user of the hearing aid, with the switch device in accordance with the present invention, does not result in a corresponding unpreciseness of the electrical switch signal to be generated, particularly if deriving of such electrical switch signals from the electrical output oscillations of the second piezoelectric element involves comparing the output oscillations with threshold values in a comparator.

If any stage of the hearing aid circuitry comprises a local oscillator or a clock signal generator, the oscillations thereof could be used in a rather advantageous way for exciting the first piezoelectric element of the switching device.

### BRIEF DESCRIPTION OF THE DRAWINGS

The invention will be more easily understood by the person skilled in the art from the following description of preferred embodiments in connection with the drawings. In the Figures thereof:
- Fig. 1: shows a schematic diagram of a hearing aid circuitry with a switch device in accordance with the present invention;
- Fig. 2: shows in analogous manner to Figure 1, a hearing aid circuitry with digital processing of signals and with a switch device in accordance with the present invention;
- Figures 3 to 5: show in schematic view several embodiments of a switch device of the present invention.

### DETAILLED DESCRIPTION OF THE EMBODIMENTS

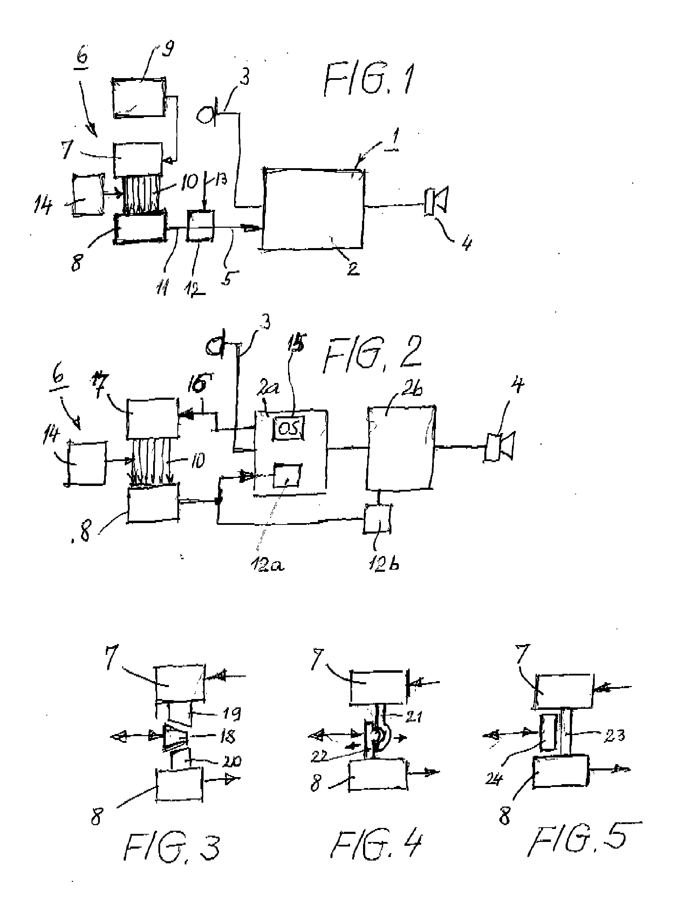

Referring to Figure 1 there is shown a hearing aid 1 comprising an IC hearing aid circuitry with an electric energy source and further components in a unit 2 which is connected with a microphone 3 and a speaker 4. An electrical switch signal can be fed to the unit 2 via a switch signal line 5 for switching the unit 2 from one to another processing mode, e.g., from a high to a low sensitivity or volume and vice versa, for switching the unit 2 from one specific frequency selection to another, etc.

The electric switching signal on line 5 is generated by a switch device 6, which comprises a first piezoelectric element 7 and a second piezoelectric element 8. The first piezoelectric element is provided with electrodes not shown in the drawings and is connected via the electrodes to an electric oscillator 9 the electric oscillations of which excite the first piezoelectric element so that it generates mechanical oscillations which are transmitted to mechanical oscillation transmitting means shown schematically at 10. The mechanical oscillation means 10 transmit the mechanical oscillations to the second piezoelectric element 8 which, in response thereto, provides electrical oscillations at electrodes of the second piezoelectric element which are not shown in the drawings. These electrical oscillations are fed from the electrodes via a signal line 11 to a processor 12, which serves for deriving from the electrical oscillations the electrical switching signal which is output at line 5 and fed to unit 2 of the hearing aid.

The processor 12 can include means for rectifying the electrical oscillations output by the second piezoelectric element 8, for integrating the output, comparing it with a threshold value input to the processor 12 at line 13 and, as the case may be, can invert the derived signal for inputting an inverse electrical switch signal via line 5 to unit 2.

Any modulation of the transmitting characteristics of the mechanical oscillation transmission means 10 depending from a mechanical input given by the user of the hearing aid is caused by modulating means 14 coupled to any mechanical input means operated by the user of the hearing aid and serving for either establishing or interrupting or increasing or attenuating the mechanical coupling between the first piezoelectric element 7 and the second piezoelectric element 8.

It should be noted here that the mechanical oscillation transmission means 10 could be also a direct interface formed by the opposing surfaces of the first piezoelectric element 7 and the second piezoelectric element 8 in accordance with a modified embodiment of the basic structure of Figure 1 so that the modulating means 14, in this case, for interrupting the mechanical transmission between the piezoelectric elements 7 and 8, would separate the elements from each other upon a mechanical input from the user or would bring both piezoelectric elements in contact with each other for establishing the mechanical transmission for transferring the mechanical oscillations from the first piezoelectric element to the second piezoelectric element.

The embodiment of Figure 2 is different from the embodiment of Figure 1 in that, in the embodiment of Figure 2, the signals from the microphone 3 are converted from analogue signals into digital signals in subunit 2a and are processed in this subunit in a manner known to the person skilled in the art. Thereafter, the processed digital signals are reconverted in analogue signals in subunit 2b for being output to the speaker 4. The A/D-converting subunit 2a comprises a clock signal generator 15, the output of which, after adequate processing and amplification, can be used for exciting the first piezoelectric element 7 via line 16.

The mode of operation of the switch device 6 of Figure 2 is similar to the mode of operation of the switch device of the embodiment described in connection with Figure 1.

As shown in the circuit diagram of Figure 2, deriving and processing of the electric oscillations output from the second piezoelectric element 8 can take place in a processor 12a being part of the subunit 2a, and could also take place in a processor 12b for feeding an electrical switch signal of another kind to the subunit 2b of the hearing aid circuitry.

Figures 3 to 5 show some practical implementations of the mechanical oscillations transmission means and of the modulating means between the first piezoelectric element 7 and the second piezoelectric element 8 of the switching device of this invention.

In accordance with Figure 3 it is a wedge formed body 18 which is pressed in a gap between portions 19 and 20 being part of mechanical oscillation transmission means for completing or interrupting the mechanical oscillation transmission path between the piezoelectric elements 7 and 8.

In accordance with Figure 4 the mechanical oscillation transmission means have the shape of coupling elements 21 and 22 being biased in a direction out of engagement by inherent spring characteristics and being engageable by the modulating means under the effect of the mechanical input from the user.

In accordance with the embodiment of Figure 5, the mechanical oscillation transmission means have the shape of a comparatively narrow transmission path 23 wherein the transmission of mechanical oscillations can be attenuated by pressing an attenuating body 24 sidewise against one side surface of transmission path 23 by the modulating means under the effect of the mechanical input from the user.

From the above description it becomes clear that providing two piezoelectric elements of which one is the transmitter and the other is the mechanical receiver, a precise tuning of the respective frequencies can be obtained which is not dependent from influences resulting from the operation of the switch device by the user of the hearing aid and which is not influenced by e.g. corrosive environmental conditions which can easily be held off by hermetically encapsulating the whole device.

Generating a special kind of the desired electric switch signal is not left to any special activation by the user of the hearing aid but is left to the processing means deriving the electrical switch signal from the electrical oscillations of the second piezoelectric element. Thus, the generated electrical switch signal is not dependent from the preciseness or duration or amplitude of the mechanical input from the user of the hearing aid.

## Claims

1. Switch device for generating an electrical switch signal for a hearing aid circuitry by a mechanical input from a user of the hearing aid, comprising
an electrical switch signal output (5) connected to said hearing aid circuitry;
electrical switch signal generating means (6) coupled to said output; and mechanical input means coupled to said electrical switch signal generating means;
**characterized in that**
said electrical switch signal generating means (6) comprise a first piezoelectric element (7) connected to an electrical oscillator (9; 15) for exciting mechanical oscillations of said first piezoelectric element;
modulatable mechanical oscillation transmission means (10) between said first piezoelectric element (7) and a second piezoelectric element (8) for exciting electrical oscillations of said second piezoelectric element;
processing means (12; 12a, 12b) for deriving said electrical switch signal from said electrical oscillations of said second piezoelectric element; and
modulating means (14) coupled to said mechanical input for modulating the transmission characteristics of said mechanical oscillation transmission means (10) dependent from actuation of said mechanical input.

2. Switch device in accordance with claim 1, **characterized in that** said modulating means (14) serve for establishing the mechanical oscillation transmission by said mechanical oscillation transmission means upon actuation of the mechanical input.

3. Switch device in accordance with claim 1, **characterized in that** said modulating means (14) serve for interrupting the mechanical oscillation transmission by said mechanical oscillation transmission means upon actuation of the mechanical input.

4. Switch device in accordance with claim 1, **characterized in that** said modulating means (14) serve for increasing the mechanical oscillation transmission by said mechanical oscillation transmission means upon actuation of the mechanical input.

5. Switch device in accordance with claim 1, **characterized in that** said modulating means (14) serve for attenuating the mechanical oscillation transmission by said mechanical oscillation transmission means upon actuation of the mechanical input.

6. Switch device in accordance with one of claims 1 to 5, **characterized in that** the processing means (12; 12a, 12b) comprise a rectifier and/or an integrator and/or a comparator for comparing a derived signal with a threshold value.

7. Switch device in accordance with one of the claims 1 to 6, **characterized in that** a clock signal generator (15) of a digital part of the hearing aid circuitry is used as said electrical oscillator for exciting mechanical oscillations of the first piezoelectric element (7).
